(19) Europäisches Patentamt
European Patent Office
Office européen des brevets

(11) EP 2 051 086 A2

(12) EUROPEAN PATENT APPLICATION

(43) Date of publication:
22.04.2009 Bulletin 2009/17

(51) Int Cl.:
G01R 31/34 (2006.01)

(21) Application number: 08166415.3

(22) Date of filing: 13.10.2008

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 15.10.2007 US 872211

(71) Applicant: GENERAL ELECTRIC COMPANY
Schenectady, NY 12345 (US)

(72) Inventors:
• Flickinger, Greg L.
Pittsburg, PA 15229 (US)
• Chmiel, Gary J.
Ballston Spa, NY 12020 (US)
• Johnson, David N.
Frenchtown, MT 59834 (US)

(74) Representative: Gray, Thomas
GE International Inc.
London Patent Operation
15 John Adam Street
London WC2N 6LU (GB)

(54) **Method and system for remotely predicting the remaining life of an AC motor system**

(57)   A method and system for remotely predicting the reliability and the remaining time before failure for an AC motor system (110) is provided. The method and system may remotely determine the reliability and a remaining time before failure with a statistical confidence utilizing an AC motor condition forecaster (140). The method and system may include acquiring historical motor data, obtaining operational data (120), performing failure analysis, developing a causal network, and performing an integrated causal network and reliability analysis of the AC motor system. The method and system may provide at least one notification of an issue with the AC motor system (110) or at least one component of the AC motor system.

FIG. 1

Description

BACKGROUND OF THE INVENTION

The present invention relates to the reliability of an AC motor system, and more particularly to a method and system for remotely determining, with an ascertained statistical confidence, a remaining time before failure of a component with the AC motor system.

Some operators of AC motor systems employ some form of a remote monitoring and diagnostics (RM&D) system, or the like, for use in determining the reliability of the system. Currently known RM&D systems tend to focus on the collection for trending purposes.

Acquisition of accurate information concerning the running condition, status and performance of AC motor systems, such as, for example, but not limiting of, electric motors used in "critical" industrial manufacturing processes, power generation systems, or the like; is often crucial in maintaining successful commercial operation of such systems. Consequently, considerable efforts are often expended to develop and improve upon existing methods and systems used for monitoring and diagnosing the operation and performance of electric motors and coil devices in such systems. Robust methods of inspection are often desired for such critical process motors, since if a motor must be taken off-line, its inoperability may adversely impact revenue generation.

Robust processes for the inspection and predictive maintenance of AC motor systems usually involve monitoring a variety of operational parameters such as motor current, voltage, vibration, flux leakage, etc. to detect impending failures. Conventionally, one or more parameters are monitored over time and used to trigger a maintenance outage/recommendation when the value of a monitored parameter exceeds a predetermined threshold. The contemporary technological trend is to automate the inspection process by affixing a variety of sensors and transducers to the AC motors to continuously collect information through either off-line monitoring or on-line monitoring techniques. Operational indicators for an operating motor may then be tracked continuously and an alarm may be immediately triggered if a predetermined threshold value for a particular indicator is exceeded. For example, but not limiting of, vibration amplitude or spectral data that exceeds or drifts from a predetermined range or value can be used to activate an alarm to notify the equipment operator that a particular type of failure mode is imminent.

The use of motor operational indicator data as a failure predictive tool and to assess motor health has been explored to some extent in the past by various investigators. Different AC motor system indicators may be used for this purpose and may include AC motor system "unbalances" such as negative sequence currents, and voltage mismatch.

There are drawbacks with the currently known methods of remotely monitoring and diagnosing the remaining life of an AC motor system. The conventional RM&D systems typically target only data that may represent an imminent failure and do not provide a quantitative determination of remaining motor life or motor reliability. Some conventional systems provide only a general warning of imminent motor failure based on the detection of an alarm condition from a single monitored indicator. These systems may not provide an assessment of motor reliability, nor do they provide an estimate of the operating time remaining until a repair will be needed.

For the foregoing reasons, there is a need for a method and system for remotely determining the remaining life of an AC motor system. The method and system should receive a plurality of operating data on the components of the AC motor system. The method and system should also analyze motor data and determine the motor reliability and estimated operating time until a failure based on an insulation condition of the AC motor system.

BRIEF DESCRIPTION OF THE INVENTION

In accordance with an embodiment of the present invention, a method of remotely determining both reliability and a remaining time before a failure for at least one AC motor system located on a site, the method comprising: providing at least one remote monitoring and diagnostics (RM&D) system, wherein the at least one RM&D system is at a location different from the site having the at least one AC motor system; integrating the at least one RM&D system with at least one condition forecaster,

wherein the at least one condition forecaster receives a plurality of operating data from the at least one AC motor system; receiving the plurality of operating data from the condition forecaster; transmitting a plurality of historical operating data corresponding to the at least one AC motor system from at least one historical database to the at least one RM&D system; utilizing the plurality of operating data to determine whether reliability and the remaining time before the failure of the at least one AC motor system are within an alarm range; and if reliability and the remaining time before the failure of the at least one AC motor system are within the alarm range; then notifying at least one support network.

In accordance with an alternate embodiment of the present invention, a method of remotely determining both reliability and a remaining time before a failure for at least one AC motor system located on a site, the method comprising: providing at least one remote monitoring and diagnostics (RM&D) system, wherein the at least one RM&D system is at a location different from the site having the at least one AC motor system; integrating the at least one RM&D system with at least one condition forecaster, wherein the at least one condition forecaster receives a plurality of operating data from the at least one AC motor system; wherein the at least one condition forecaster comprises the steps of: performing at least one failure analysis based on a composite of reliability probability distributions corresponding to predetermined sub-populations of historical failure causes relating to the at least one AC motor system; developing at least one causal network for modeling reliability of a plurality of AC motor systems, including the at least one AC motor system and assessing at least one AC motor system component condition based on the causal network; and performing at least one integrated causal network and reliability analysis of the at least one AC motor system utilizing a Weibull probability distribution function; wherein results from the at least one analysis is integrated with results from the step of assessing the at least one AC motor system component condition based on the at least one causal network to compute a quantitative value for a time remaining before the failure; transmitting the plurality of operating data from the condition forecaster to the at least one RM&D system, wherein the plurality of operating data comprises data from at least one tan delta sensor; receiving a plurality of historical operating data corresponding to the at least one AC motor system from at least one historical database; utilizing the plurality of operating data to determine whether reliability and a remaining time before a failure of the at least one AC motor system are within an alarm range; and if reliability and the remaining time before the failure of the at least one AC motor system are within the alarm range; then notifying at least one support network.

In accordance with another alternate embodiment of the present invention, a system for remotely determining both reliability and a remaining time before a failure for at least one AC motor system located on a site, the system comprising: at least one remote monitoring and diagnostics (RM&D) system, wherein the at least one RM&D system is located at a site different from the site having the at least one AC motor system, wherein the at least one RM&D system monitors a plurality of operating data of the at least one AC motor system; at least one condition forecaster, wherein the at least one condition forecaster: performs at least one failure analysis based on a composite of reliability probability distributions corresponding to predetermined sub-populations of historical failure causes relating to the at least one AC motor system; develops at least one causal network for modeling reliability of a plurality of AC motor systems, including the at least one AC motor system and assessing at least one AC motor system component condition based on the causal network; and performs at least one integrated causal network and reliability analysis of the at least one AC motor system; wherein results from the at least one analysis is integrated with results from the step of assessing the at least one AC motor system component condition based on the at least one causal network to compute a quantitative value for a time remaining before the failure; wherein the plurality of operating data comprises data from at least one tan delta sensor; and means for integrating the at least one RM&D system with the at least one condition forecaster; and

means for transmitting the plurality of operating data from the condition forecaster to the at least one RM&D system.

## BRIEF DESCRIPTION OF THE DRAWINGS

There follows a detailed description of embodiments of the invention by way of example only with reference to the accompanying drawings in which:

Figure 1 is a schematic illustrating the environment in which an embodiment of the present invention operates;

Figure 2 is a graph illustrating the useful life span of a motor system part as a function of failure rate and time in service;

Figure 3 is a fishbone diagram illustrating exemplary electrical, mechanical, environmental, and systemic issues that may cause/contribute to motor system failure;

Figure 4 is a high-level flow diagram illustrating a method utilized by a condition forecaster in accordance with an embodiment of the present invention;

Figure 5 is a detailed flow diagram illustrating the method of Figure 4 in accordance with an embodiment of the present invention;

Figure 6 is a schematic view illustrating a sensor configured to acquire field data in accordance with an embodiment of the present invention;

Figure 7 is a waveform diagram illustrating leakage current measured by the sensor of Figure 6;

Figure 8 is a flowchart illustrating an example of a method of utilizing a RM&D system to predict the remaining life of an AC motor system in accordance with an embodiment of the present invention; and

Figure 9 is a block diagram of an exemplary system for remotely predicting the remaining life of an AC motor system in accordance with an embodiment of the present invention.

## DETAILED DESCRIPTION OF THE INVENTION

The following detailed description of preferred embodiments refers to the accompanying drawings, which illustrate specific embodiments of the invention. Other embodiments having different structures and operations do not depart from the scope of the present invention.

An embodiment of the present invention takes the form of an application and process that has the technical effect of determining the remaining life of at least one AC motor system from a remote location. The present invention can be applied to AC motor systems used in a variety of applications, including: industrial processes, powerplant processes; and combinations thereof.

An AC motor system may include an AC motor and at least one of the following:

> sensors, transmitters, temperature elements, or the like, and combinations thereof which may monitor the AC motor.

A remote monitoring and diagnostics (RM&D) system may be located on a site different from the location of the at least one AC motor system. The RM&D system may include a plurality of transmitters and receivers that are either wireless connected to and/or wired to the site operating the AC motor system; and receive operating data from that site. Typically the RM&D system includes a plurality of computer systems, servers, and software tools. A team who may operate the RM&D system may employ the software tools to remotely determine an operating status of the at least one AC motor system.

The software tools of the RM&D system may include the performance of, for example, but not limiting of, the following tasks. Remote Monitoring - which may involve monitoring of operational data using automated and manual techniques, allows the team to support site operational activities. Decision Support - which may assistance an operator of the AC motor system in understanding the operation, process deviations, and unforeseen operational event situations that may occur. The decision support many also provide recommended trouble-shooting steps. Operational Data Archive and Retrieval - store operational data that may be retrieved. Operational data may be used to provide operational records for unit operational comparisons, detection of developing technical issues, and assist in determining the root cause of unforeseen operational events. Reporting - operational assessment reports may be generated to provide a record of key operating parameters and significant operational events, trends and anomalies. This data is summarized to assist with the identification of performance shortfalls and the planning of maintenance activities.

The RM&D system may receive data (hereinafter operating data) corresponding to the at least one AC motor system. An AC motor system may have a plurality of operational indicators corresponding to the sensor, transmitter, temperature element, or the like, which may be part of the AC motor system, as described. The operational indicators may be used for determining the reliability of the AC motor. For example, but not limiting of, the name of the operational indicator representing a vibration level on the AC motor may be "Vib_1". The corresponding operating data may provide values for Vib_1 over a specified range of time, which may be received by the RM&D system.

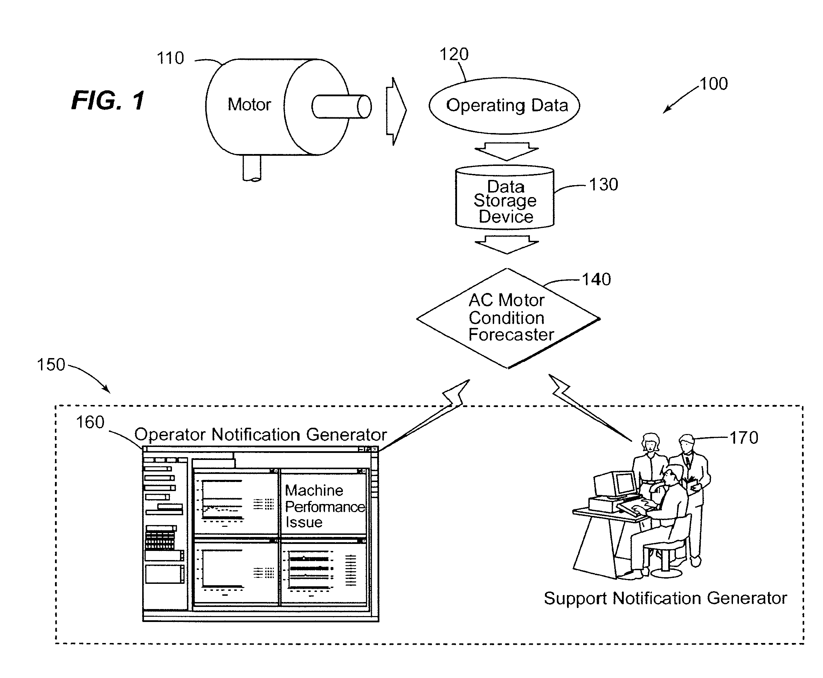

Referring now to the Figures, where the various numbers represent like elements throughout the several views, Figure 1 is a schematic illustrating the environment in which an embodiment of the present invention operates. Figure 1 illustrates a site 100 comprising an AC motor system 110; a plurality of operating data 120; a data storage device 130; an AC condition forecaster 140; and a RM&D system 150 comprising an operator notification generator 160, and a support notification generator 170.

The site 100 may comprise at least one control system or the like (not illustrated) which may receive the plurality of operating data 120 from the AC motor system 110. The plurality of operating data 120 may comprise operational indicators corresponding to the thermal, chemical, mechanical, and electrical operating data; and may be used in evaluating the reliability of the AC motor system 110.

The plurality of operating data 120 may be transmitted to at least one data storage device 130, which may, inter alia, collect, process, and store, the plurality of operating data 120. The data storage device 130 may be approximately located at the site 100.

In an embodiment of the present invention, a data storage device 130 may transmit the plurality of operating data 120 to at least one AC motor condition forecaster 140, which may be approximately located at the customer site 100.

The AC motor condition forecaster 140 may predict the reliability and estimate a time to failure of at least one component of and/or the entire the AC motor system 110. The AC motor condition forecaster 140 may be integrated with at least one RM&D system 150.

The RM&D system 150 may, be provided with and/or include a plurality of rules, or the like. The plurality of rules may detect, the likelihood of a failure of a component on the AC motor system 110, for example, but not limiting of, in real time.

The RM&D system 150 may, depending on the nature and severity of a detected issue, transmit the details of a determined issue to at least one operator notification generator 160 and/or at least one support notification generator 170.

The operator notification generator 160 may automatically provide the operator of the AC motor system 110 with a notification of the issue. In an embodiment of the present invention, the notification may provide at least one recommendation for resolving the issue.

The support notification generator 170 may automatically provide a third-party support system with the details of the discovered issue. Here, for example, but not limiting of, the third-party support system may be contacted if the RM&D system 150 determines that the issue requires the involvement of an expert.

Before continuing the discussion on an embodiment of the RM&D system 150 of the present invention, further discussion on an embodiment of the AC motor condition forecaster 140 is provided next.

Industrial and power generation motors are often supplied and installed with operational indicators to indicate running conditions for the purpose of trending operational indictor data and planning maintenance procedures. Operational indicators may be configured to provide online and/or offline testing of an electric motor. Online testing has advantages over offline testing due to an ease of data acquisition and an ability to avoid downtime of the electric motor. Operational indicators used for online testing are configured to acquire operational parameters of the AC motor 110. The operational indicators may include, for example, but not limiting of, voltage, current, phase, frequency, total vibration amplitude, torque, and slip.

A method has been designed for remotely forecasting both a failure mode and the remaining life in electric motors, based on sensor inputs including the operational parameters. The method may incorporate a large database of inspection information and industry standard data utilized for a probabilistic analysis of the sensor inputs and a causal network, utilizing Fuzzy Logic, employed to relate various inputs with potential results.

Engineering systems analysis has been successfully applied to reliability calculations in related fields such as electronic devices. Mean-time-to-Failure (MTTF) data are collected on various components of a system. A designer then calculates system reliability based upon reliability block diagrams and produces an overall system reliability distribution, R. The dependence of R is a function of individual parameters of the system, $\lambda$, as described below:

$$R = f(\lambda_1, \lambda_2, \ldots \lambda_n)$$

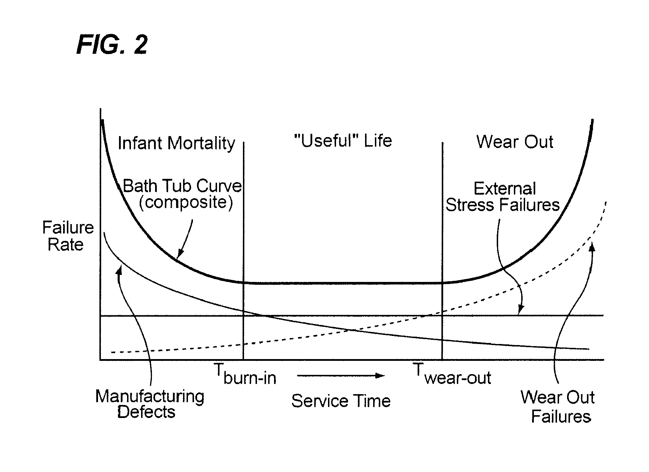

Each of the individual parameters $\lambda$, describes a failure rate of a corresponding component of the system. Each component of the system experiences a useful life that can be described in terms of a "bath tub" curve, see Figure 2.

If failure rates of multiple components are independent, then a multiplicative relationship can be used to calculate system reliability:

$$p(\lambda) = \prod_{i=1}^{k} f(\lambda_i)$$

Otherwise a simulation of a joint, dependent probability density function (pdf) is required. The method is to randomly sample a joint pdf, compute a reliability for that run and then construct an overall reliability distribution function based on an accumulation of runs. Component life is distributed according to a probability density function and may take the form of an exponential, log-normal or Weibull distribution. The Weibull distribution is most useful due to its flexible shape of the distribution with shape and scale parameters, $\beta$ and, $\eta$ where (t) is a time range:

$$f(t) = \frac{\beta}{\eta}\left(\frac{t}{\eta}\right)^{\beta-1} e^{-\left(\frac{t}{\eta}\right)^{\beta}}$$

Data for the individual Weibull distributions described by the shape and scale parameters, $\beta$ and, $\eta$ can be extracted from a database compiled from cataloged root cause failures for a variety of components. The indicators can be used to accelerate the scale, $\eta_f$, of the Weibull distribution through influence relationship such as an Arrhenius equation. An acceleration factor (*Af*) using the Arrhenius equation may be given by:

$$Af = \exp(\mathrm{actE}/V_n - \mathrm{actE}/V_a).$$

Here the activation energy (actE) may be set to 0.1, $V_n$ may be a constant set to 1, and

$$V_a = 1 / E[\mathrm{indicators}]$$

Where a function E is used to aggregate the number and duration of the indicators over time. In an embodiment of the present invention, a regression may be performed over the prior history of the data. However other methods such as, but not limiting of, a fading model that reduces the effect of the indicators over time when not present. The activation energy and $V_n$ constants may be re-calibrated when there is sufficient failure data to do so. When there is no data to predict a failure then the acceleration factor (*Af*) may be set to 1. The acceleration factor reduces the scale parameter in the life calculation to:

$$\eta_f = \eta / Af$$

This method, because or the simplicity, may be used to accelerate the life calculation. However, other methods may be used to accelerate the life calculation equation.

Conditional probabilities, *f*(*A*(*t*)|*B*(*t*)) of motor reliability are determined through a collection of field data of the system. In general, a conditional probability refers to the probability of event *B* happening, given that event A has already occurred. The collection of field data is accomplished, for example, but not limiting of, using either online or offline methods of data collection. The conditional probabilities may be used when constructing the causal network assessment (fuzzy model for example, but not limiting thereof).

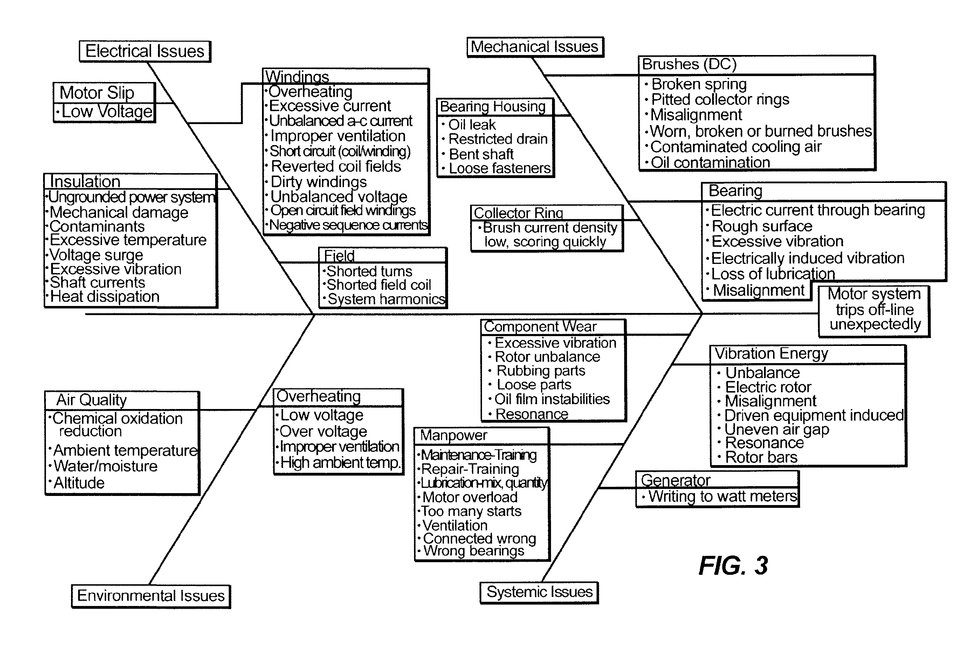

Figure 3 is a fishbone diagram illustrating exemplary electrical, mechanical, environmental, and systemic issues that may contribute to motor system failure The fishbone diagram shown in Figure 3 illustrates one example of a system fault-tree analysis that considers various factors and component failure modes, which may cause or contribute to an overall motor system failure. Known component failure modes and other causes/factors that have historically caused an electrical motor system or electrical generator to trip off-line unexpectedly (i.e., an operational shutdown of the system) are listed within one or more cause related subcategories.

The subcategories are further organized according to more general fault issue classes/categories that are indicative, for example, but not limiting of, but not limiting of, of whether the cause of failure is related to systemic, environmental, electrical or mechanical issues. Typically, the various component failure modes and causes of faults used in the system fault-tree analysis are developed from and based upon historical empirical data, tests and observations collected over a reasonable period of time from a plurality of motor systems.

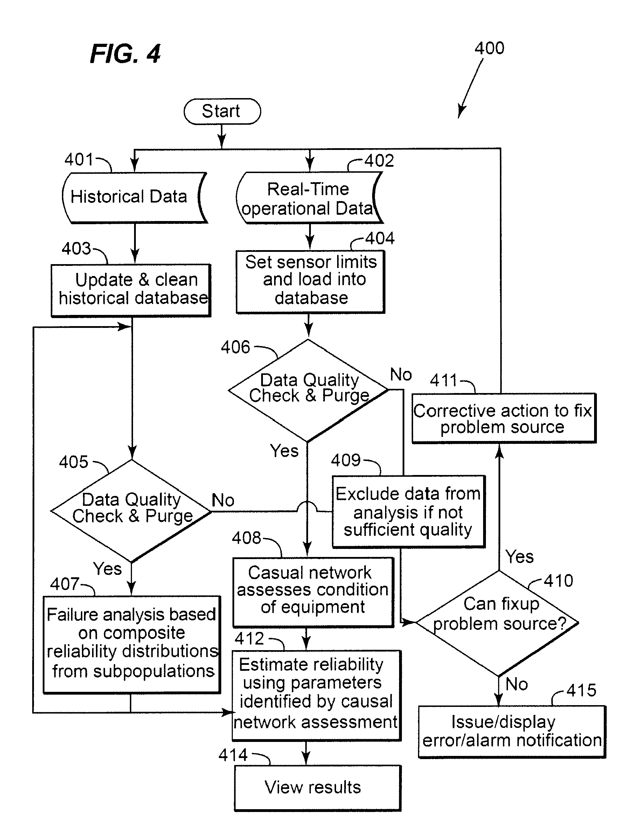

Figure 4 is a high-level flow diagram illustrating a method 400 utilized a condition forecaster 140 in accordance with an embodiment of the present invention. Figure 4 also illustrates an example embodiment of the condition forecaster 140 that may be integrated with the RM&D system 150.

The method 400 initially involves receiving and organizing historical motor repair data into a database in step 401. The historical motor repair data acquired in step 401 corresponds to a same or similar motor systems. In step 403, the database is updated and purged to remove any erroneous or irrelevant data. In step 405, data quality checking and purging is performed.

If the method 400 determines that the data quality is acceptable in step 405, then in step 407 at least one failure analysis for the AC motor system 110 may be performed based on a composite of reliability distributions corresponding to various sub-populations of electrical, mechanical, environmental, and systemic fault issues/ failure modes; then the method 400 may proceed to step 412 where an estimate of reliability using parameters identified by causal network assessment may be performed, as discussed below.

The method 400 may proceed to step 409 if the data quality checking and purging performed in step 405 has discovered errors. In step 409 any data that does not meet a predetermined quality criterion may be excluded from use in the current analysis.

The method 400, in step 410, may determine if the problem source of the excluded data can be fixed. If the problem source of the excluded data may be fixed, then the method 400 may proceed to step 411; otherwise the method 400 may proceed to step 415. In step 411, the method 400 may perform at least one corrective action to fix the problem source of the excluded data. In step 415, the method 400, may provided a notification, or the like, of the issue or error with the excluded data to the user.

The method 400 may also execute a series of concurrent steps (402 - 408), while executing steps 401-407. In step 402, the method 400 may monitor and acquire the current operational data 120, in real-time, from the operational indicators of the AC motor system 110 for which a reliability and time-to-failure assessment may be desired. The current operational indicator data 120 may also be compiled in another database in step 402 (or integrated into the historical database) and continually updated.

In step 404, the method 400 may set sensor limits and load into the database those limits. Specific data ranges and limits or calculated metrics for the particular AC motor 110 operational indicators may also be set and monitored in the database and used, for example, but not limiting of, to trigger a notification/alarm condition when appropriate in step 404.

The method 400 may also perform data quality checks and purging in step 406, similar to step 405. If step 406 determines that the data meets a predetermined quality criterion, then the method 400 may proceed to step 408; otherwise the method 400 may proceed to step 409, as discussed and whereby after step 409 is performed the method 400 may then revert to step 402.

In step 408, the method 400 may provide at least one casual network, which may assess the condition of the components of the AC motor system 110. The causal network may develop at least one condition used for developing failure modes.

In step 412, the method 400 may estimate reliability using parameters identified by the causal network assessment of step 408. Here, the method 400 may integrate/combine the results of reliability analysis from the historical data, correlate the results from the casual network assessment of step 408, and then develop a statistically reliable prediction of time remaining before failure. Step 412 may perform a method similar to the aforementioned; integrating data from step 407 instead of step 408.

In an embodiment of the present invention, implementation of the method 400 may include computing the Maximum Likelihood Estimate (MLE) of Weibull reliability parameters for the AC motor system 110 and/or the equipment components identified by the causal network.

In step 414, the method 400 may allow a user to view results of the analysis discussed above. Computed statistical estimations of system reliability and time remaining before failure may be displayed using conventional computer I/O interface/display devices. In an embodiment of the present invention, the time remaining before failure and computed reliability are displayed using dynamic graphical images such as, but not limited to, a moving bar graphs and changing data odometers, or the like.

In general, the various data validation and calibration steps (e.g., 405 and 406) may be avoided however, use of such may improve both the failure analysis, and the causal networks relied upon for developing statistical predictions of reliability.

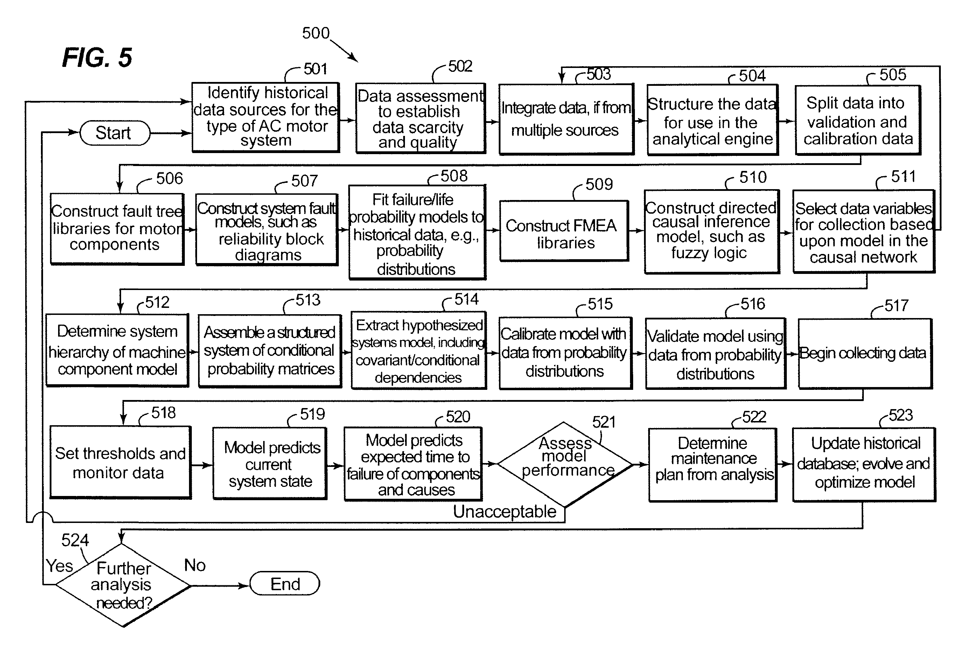

Figure 5 is a detailed flow diagram illustrating a method 500, similar to the method 400 of Figure 4 in accordance with an embodiment of the present invention. Figure 5 provides a detailed procedural flow diagram that illustrates the method 500 for computing motor reliability and predicting time-to-next-repair (or failure) that may be used by the condition forecaster 140 and integrated with the RM&D system 150.

In step 501, the method 500 may identify historical data sources for the type of AC motor system 110. In step 501, for example, but not limiting of, historical test data and/or failure analysis records acquired over a period of time for the type of AC motor system 110 being evaluated may be identified and a historical database of part/component failure rate data may be compiled. The historical database may be maintained and motor reliability computations performed by the RM&D system 150. The historical database may also be updated by at least one manual data transfer means using, for example, but not limiting of, removable storage media (e.g., CD ROM, compact flash, or the like).

The method 500 in steps 502 through 511 may represent general data preprocessing steps performed to structure and combine historical motor data that may be later used for reliability computations. In step 502, the method 500 may perform a data assessment to determine scarcity and quality of the data received in step 501. In step 503, the method 500 may integrate the data if acquired from multiple sources. Next, in step 504, the method 500 may structure the data for use by the analytical engine. Next, in step 505, the method 500 may split data into validation and calibration type data. Next, in step 506, the method 500 may construct system fault tree libraries for the AC motor system 110 components. Next, in step 507, the method 500 may construct system fault models (such as, but not limiting of, reliability block diagrams).

Next, in step 508, the method 500 may fit the failure/life-span probability models to the historical data (e.g., using for example, but not limiting of, a probability distribution, or the like). Next, in step 509, the method 500 may construct a plurality of libraries, such as but not limited to, Failure Modes and Effects Analysis (FMEA) libraries to identify common failure modes. Next, in step 510, the method 500 may construct directed causal inference models, networks or the like; such as, but not limited to, Fuzzy Logic. The models may be used to compute conditional probability of motor component degradation. Next, in step 511, the method 500 may select data variables for collection based upon model in the causal network.

Steps 512 through 514, of the method 500, illustrate procedural steps for segmenting the AC motor system 110 by component and establishing dependencies within the causal network. For example, but not limiting of, a system hierarchy of a machine component model may be determined in step 512; a structured system of conditional probability matrices may be assembled in step 513; and a hypothesized systems model including covariant/conditional dependencies may be then extracted in step 514.

Next, in steps 515 and 516, the systems model, discussed in steps 512-514, may be properly calibrated with respect to the AC motor system 110 under investigation. For example, but not limiting of, the systems model may be calibrated with data from probability distributions in step 515; and then validated using data from probability distributions in step 516.

In step 517, the method 500 may begin collecting data. Step 517 may represent the initiation of a procedural stage of field data collection from the operational indicators that may be attached to the AC motor system 110 under analysis. At this point, current operational/test data may be obtained on the particular AC motor system 110 under analysis and sent to the RM&D system 150 which may perform the analysis. This field data may be collected from operational indicators on the AC motor system 110 or other conventional means at the site 100.

In step 518, the method 500 may set thresholds and monitor data. In step 518, the AC motor system 110 thresholds and alarm limits may be constructed/set-up, and the field data from the motor system may be monitored. If the thresholds or alarm limits are exceeded some form of real-time feedback, such as, but not limiting of, an alarm notification may be immediately provided.

In step 519, the method 500 may predict a current state of the AC motor system 110. As illustrated in step 519, the "state" of the AC motor system 110 may be predicted based on the causal network, the thresholds, and the monitor data acquired in step 518.

In step 520, the method 500 may use the system model to predict expected time-to-failure of the various AC motor system 110 components. Step 520 may also determine the cause of the predicted failures. In an embodiment of the present invention, the system model may also predict for example, but not limiting of, covariant/conditional dependencies.

Next, as illustrated in steps 521 and 522, decision points may be reached whereby an operator of the RM&D system 150 may need to evaluate: alarm conditions; assess the model's performance; and/or decided on whether repair or replacement of a component is recommend. If an operator determines in step 521 that the assessed performance of the model yields inaccuracies, then the method 500 may proceed to step 524; otherwise the method 500 may proceed to step 522. In step 522, the method 500 may determine a maintenance plan from the analysis. Here, for example, but not limiting of, an operator may develop the maintenance plan.

Next, steps 523 and 524 may illustrate further steps, which may be taken to improve the predicting capabilities of the causal networks and optimize the reliability model. In step 523, the method 500, may update the historical database with acquired data, evolve, and optimize the model to increase accuracy. In step 524, the method 500 may determine whether further analysis may be required. In step 524, if an operator determines that the system model may be inaccurate or unrealistic, the whole method 500 may be re-initiated. If an operator determines that the method 500 may need to be re-initiated then the method 500 may revert to step 501; otherwise the method 500 has ended.

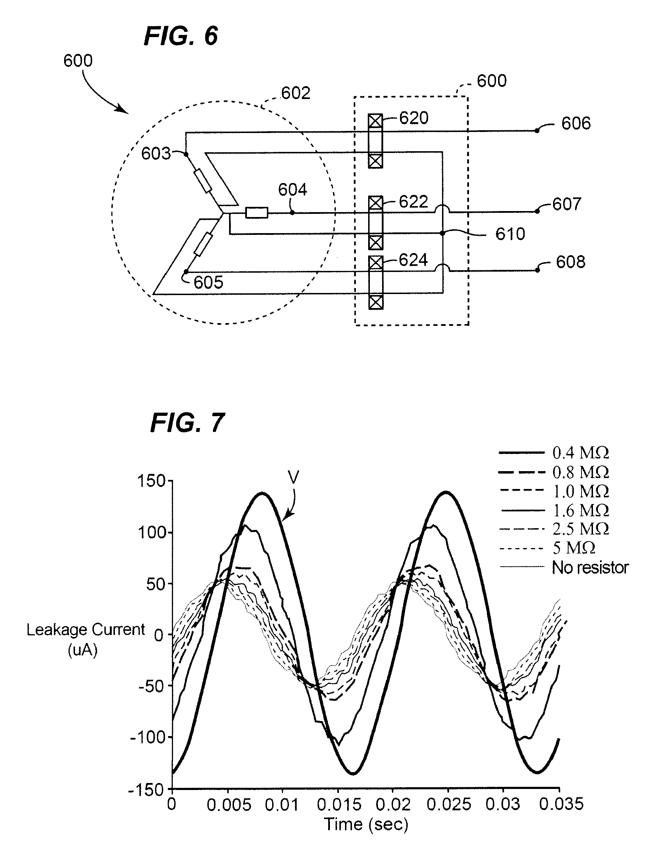

Figure 6 is a schematic view illustrating a sensor configured to acquire field data according to an embodiment of the present invention. Figure 7 is a waveform diagram of leakage current measured by the sensor of Figure 6. The sensor may be a "tan delta" sensor assembly 600. The tan delta sensor assembly 600 may be used to acquire field data from an AC machine 602 including, for example, but not limiting of, a motor or a generator. Although the AC machine 602 may be a generator, the following description relates to an AC machine 602 that may be in the AC motor system 110. The AC machine 602 includes three phase windings, a first phase winding 603, a second phase winding 604 and a third phase winding 605. A phase voltage may be applied to each of the first, second and third phase windings 603, 604 and 605 via a corresponding first input terminal 606, second input terminal 607 and third input terminal 608, respectively. An output terminal of each of the first, second and third phase windings 603, 604, and 605 may be connected to a common or a neutral node 610.

The tan delta sensor assembly 600 may be disposed proximate to the AC machine 602 to measure a leakage current. The tan delta sensor includes a first current transformer 620, a second current transformer 622, and a third current transformer 624. First, second and third current transformers 620, 622 and 624 may be for example, but not limiting of, differential current transformers. The first, second and third current transformers 620, 622 and 624 are donut or annular shaped current transformers that are disposed proximate to the AC machine 602 such that conductors carrying both a supply current and a return current are passed through a center portion of each annular shaped current transformer, 620, 622 and 624. Due to an arrangement of the first, second and third current transformers 620, 622 and 624 supply and return currents tend to cancel each other out. Thus, the first, second and third current transformers 620, 622 and 624 measure a difference between the supply and return currents. The difference between the supply and return currents may be the leakage current.

As shown in Figure 7, the phase and amplitude of leakage currents may be measured. A particular phase voltage, or reference voltage V, may be illustrated. Various leakage currents are also illustrated. Each leakage current corresponds to a particular winding resistance value. Changes in amplitude of the leakage current may indicate a change in a resistance value of a phase winding being examined. Phase shifts are also visible as temporal shifts of leakage current waveforms. Phase shifts indicate changes in an impedance value of a phase winding being examined. As winding insulation breaks down over time, corresponding changes in phase and amplitude of leakage currents are detectable using the tan delta sensor assembly 600. Historical leakage current data may be compared to current leakage current data using the method for determining a motor reliability, as discussed in Figures 4 and 5, to aid in prediction of insulation breakdown caused by thermal, electrical, ambient, and mechanical stress.

As will be appreciated, the present invention may be embodied as a method, system, or computer program product. Accordingly, the present invention may take the form of an entirely hardware embodiment, an entirely software embodiment (including firmware, resident software, micro-code, etc.) or an embodiment combining software and hardware aspects all generally referred to herein as a "circuit", "module," or "system". Furthermore, the present invention may take the form of a computer program product on a computer-usable storage medium having computer-usable program code embodied in the medium.

Any suitable computer readable medium may be utilized. The computer-usable or computer-readable medium may be, for example but not limited to, an electronic, magnetic, optical, electromagnetic, infrared, or semiconductor system, apparatus, device, or propagation medium. More specific examples (a non exhaustive list) of the computer-readable medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a transmission media such as those supporting the Internet or an intranet, or a magnetic storage device. Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory. In the context of this document, a computer-usable or computer-readable medium may be any medium that can contain, store, communicate, propagate, or transport the program for use by or in connection with the instruction execution system, apparatus, or device.

Computer program code for carrying out operations of the present invention may be written in an object oriented programming language such as Java7, Smalltalk or C++, or the like. However, the computer program code for carrying out operations of the present invention may also be written in conventional procedural programming languages, such as the "C" programming language, or a similar language. The program code may execute entirely on the user's computer, partly on the user's computer, as a stand-alone software package, partly on the user's computer and partly on a remote computer or entirely on the remote computer. In the latter scenario, the remote computer may be connected to the user's computer through a local area network (LAN) or a wide area network (WAN), or the connection may be made to an external computer (for example, but not limiting of, through the Internet using an Internet Service Provider).

The present invention is described below with reference to flowchart illustrations and/or block diagrams of methods, apparatus (systems) and computer program products according to embodiments of the invention. It will be understood that each block of the flowchart illustrations and/or block diagrams, and combinations of blocks in the flowchart illustrations and/or block diagrams, can be implemented by computer program instructions. These computer program instructions may be provided to a processor of a public purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer-readable memory that can direct a computer or other programmable data processing apparatus to function in a particular manner, such that the instructions stored in the computer-readable memory produce an article of manufacture including instruction means which implement the function/act specified in the flowchart and/or block diagram block or blocks. The computer program instructions may also be loaded onto a computer or other programmable data processing apparatus to cause a series of operational steps to be performed on the computer or other programmable apparatus to produce a computer implemented process such that the instructions which execute on the computer or other programmable apparatus provide steps for implementing the functions/acts specified in the flowchart and/or block diagram block or blocks.

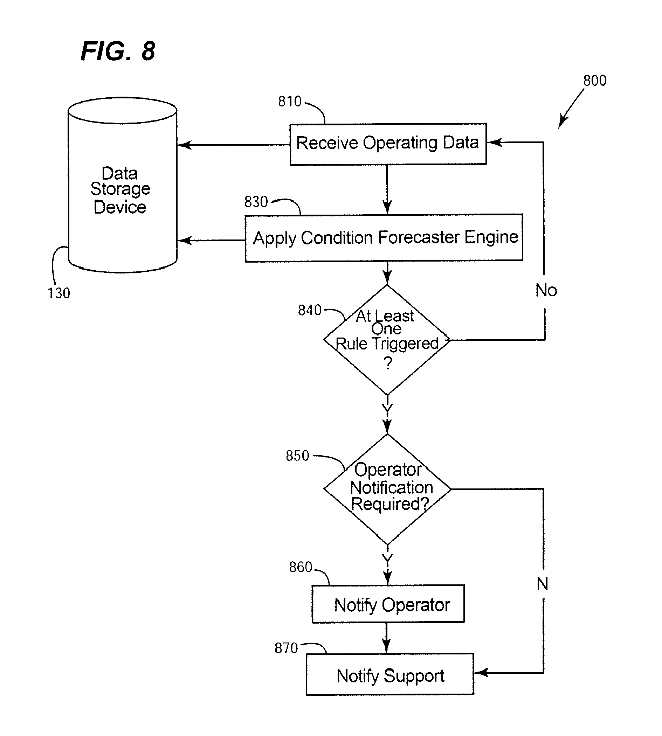

Figure 8 is a flowchart illustrating an example of a method 800 of remotely predicting the remaining life of an AC motor system in accordance with an embodiment of the present invention. The method 800 may integrate the RM&D system 150 with the AC motor condition forecaster 140.

In step 810, the method 800 may receive a plurality of operating data 120 from at least one AC motor system 110 (illustrated in Figure 1). An embodiment of the present invention may allow for receiving the plurality of operating data 120 from multiple AC motor systems 110 located on the site 100. For example, but not limiting of, the method 800, in step 810, may receive the plurality of operating data 120 from an AC motor system 110 coupled to an industrial process; an AC motor system 110 used in a distribution system; and an AC motor system 110 used in an electrical generation system; or combinations thereof.

The plurality of operating data 120 may be received at different sampling rates, or the like, such as, but not limiting of the invention, one data point per second (1/sec) or one data point per thirty seconds (1/30 sec). Generally, during the operation of an AC motor system 110, certain operating data points may be used for monitoring purposes, while other operating data points may be used for controlling or other purposes that require a higher sampling rate. Here, to conserve the storage space, which may be used to store the operating data 120, the operating data, points used for monitoring may be received at a slower sampling rate, such as 1/30 sec. Furthermore, the operating data points used for controlling may be received at a higher sampling rate, such as 1 /sec. For example, but not limiting of, an operating data point used for monitoring a vibration level may be received at a slower sampling rate, such as 1/10 sec; and an operating data point used for controlling a stator temperature may be received at a higher sampling rate, such as 1/ sec.

The plurality of operating data 120 received in step 810 may be transmitted to at least one data storage device 130. An embodiment of the present invention may allow for a plurality of data storage devices 130. For example, but not limiting of, a separate data storage device 130 may be designated for each AC motor system 110 on the site 100. The data storage device 130 may be approximately located on the site 100.

As discussed, the AC motor system 110 may include at least one control system, or the like, which typically receives the plurality of operating data 120. In step 830, the method 800 may integrate with the AC motor condition forecaster 140 which may apply at least one analysis engine to the plurality of operating data corresponding to the operational indicators. As discussed, the AC motor condition forecaster 140 may predict, in real-time, the reliability, and remaining time before a failure of at least one component of and/or the entire AC motor system 110. The evaluation may determine whether or not the at least one operational indicator is within a specified range. As discussed, the operational indicators may include for example, but not limiting of:

vibration levels, stator temperatures, current leakage data, and other data that may be used to directly or indirectly evaluate the thermal, chemical, mechanical, and

electrical characteristics of the AC motor system 110.

In an embodiment of the present invention a user, such as but not limiting of, an operator, a support expert, or the like; may select which of the plurality of operating data 120 may be associated with a operational indicator. For example, but not limiting of, an operator may select the signal name for a stator temperature (STEMP, or the like) as the operational indicator. Here, the method 800, in step 830 may apply the at least one AC motor condition forecaster 140 to the plurality of operating data 120 corresponding to the STEMP signal. The method 800, in step 830, may also transmit the plurality of operating data 120 to the at least one data storage device 130.

In step 840, the method 800 may determine whether or not at least one rule of a plurality of rules is met. Each rule of the plurality of rules may be associated with a specific reliability related issue. For example, but not limiting of, a rule may be associated with a STEMP signal. Here, if the STEMP signal is not within a specified range, the rule may be met. An embodiment of the present invention may allow for a third-party support expert, or the like, to define or modify each rule of the plurality rules. An alternate embodiment of the present invention may provide for the operator of the AC motor system 110 to define or modify each rule of the plurality rules. An embodiment of the present invention may utilize at least one math engine, or the like, to determine whether the operational indicator may be within the specified range. The math engine may also perform a plurality of statistically tests, including: normality testing; SPC rules or the like; confidence intervals; etc. If the at least one rule was met in step 840, then the method 800, may proceed to step 850, otherwise the method 800 may revert to step 810.

In step 850, the method 800, may determine whether or not at least one operator notification is required. The operator notification may alert the operator of the power plant machine 110 of a potential performance issue. An embodiment of the present invention may allow for the operator of the power plant machine 110 to select which of the plurality of rules, if met, requires an immediate notification. This feature may be very useful when monitoring a specific operational indicator associated to a rule. For example, but not limiting of, if the STEMP signal is associated with a rule, which is met, the method 800, may automatically generate a notification. If at least one operator notification is required then the method 800, may proceed to step 860, otherwise the method 800 may proceed to step 870.

In step 860, the method 800 may automatically generate an operator notification of a potential reliability issue. The operator notification may inform the operator of the AC motor system power 110 of a plurality of operating conditions related to the potential reliability issue. The operator notification may also provide recommendations for investigating the reliability issue. For example, but not limiting of, an operator notification informing the operator of an issue with the STEMP signal may provide a recommendation on how to determine whether the issue may be a fault with the STEMP signal or a genuine temperature issue within the stator of the AC motor system 110.

In step 870, the method 800 may automatically notify a support system of the potential reliability issue. The support system may include an AC motor expert, and/or others familiar with the AC motor system. The expert may analyze the plurality of operating data 120 and the results from the AC condition forecaster 140 to confirm the reliability issue and the remaining time before failure of the components of the AC motor system 110. The support system may be a third-party service of which the operator of the AC motor system 110 subscribes. For example, but not limiting of, the support system may be provided by the original equipment manufacturer (OEM), or the like.

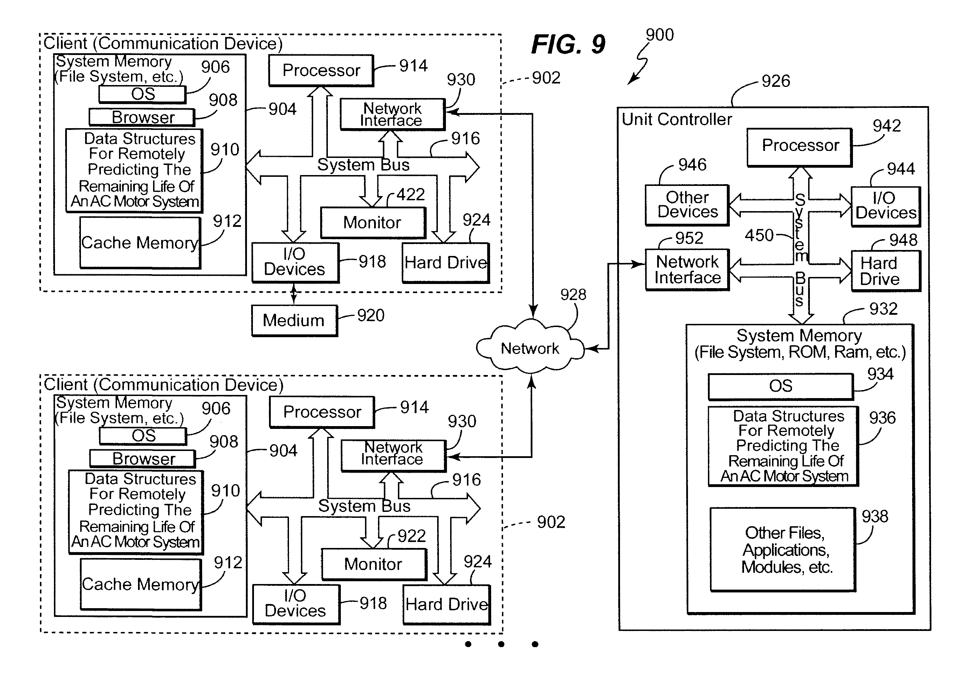

Figure 9 is a block diagram of an exemplary system 900 for remotely predicting the remaining life of an AC motor system 110 in accordance with an embodiment of the present invention. The elements of the method 800 may be embodied in and performed by the system 900. The system 900 may include one or more user or client communication devices 902 or similar systems or devices (two are illustrated in Figure 9). Each communication device 902 may be for example, but not limited to, a computer system, a personal digital assistant, a cellular phone, or similar device capable of sending and receiving an electronic message.

The communication device 902 may include a system memory 904 or local file system. The system memory 904 may include for example, but is not limited to, a read only memory (ROM) and a random access memory (RAM). The ROM may include a basic input/output system (BIOS). The BIOS may contain basic routines that help to transfer information between elements or components of the communication device 902. The system memory 904 may contain an operating system 906 to control overall operation of the communication device 902. The system memory 904 may also include a browser 908 or web browser. The system memory 904 may also include data structures 910 or computer-executable code to remotely predict the remaining life of an AC motor system 110 that may be similar or include elements of the method 800 in Figures 8.

The system memory 904 may further include a template cache memory 912, which may be used in conjunction with the method 800 in Figure 8 for remotely predicting the remaining life of an AC motor system 110.

The communication device 902 may also include a processor or processing unit 914 to control operations of the other components of the communication device 902. The operating system 906, browser 908, and data structures 910 may be operable on the processing unit 914. The processing unit 914 may be coupled to the memory system 904 and other components of the communication device 902 by a system bus 916.

The communication device 902 may also include multiple input devices (I/O), output devices or combination input/output devices 918. Each input/output device 918 may be coupled to the system bus 916 by an input/output interface (not shown in Figure 9). The input and output devices or combination I/O devices 918 permit a user to operate and interface with the communication device 902 and to control operation of the browser 908 and data structures 910 to access, operate and control the software to remotely predict the remaining life of an AC motor system 110. The I/O devices 918 may include a keyboard and computer pointing device or the like to perform the operations discussed herein.

The I/O devices 918 may also include for example, but are not limited to, disk drives, optical, mechanical, magnetic, or infrared input/output devices, modems or the like. The I/O devices 918 may be used to access a storage medium 920. The medium 920 may contain, store, communicate, or transport computer-readable or computer-executable instructions or other information for use by or in connection with a system, such as the communication devices 902.

The communication device 902 may also include or be connected to other devices, such as a display or monitor 922. The monitor 922 may permit the user to interface with the communication device 902.

The communication device 902 may also include a hard drive 924. The hard drive 924 may be coupled to the system bus 916 by a hard drive interface (not shown in Figure 9). The hard drive 924 may also form part of the local file system or system memory 904. Programs, software, and data may be transferred and exchanged between the system memory 904 and the hard drive 924 for operation of the communication device 902.

The communication device 902 may communicate with a remote server 926 and may access other servers or other communication devices similar to communication device 902 via a network 928. The system bus 916 may be coupled to the network 928 by a network interface 930. The network interface 930 may be a modem, Ethernet card, router, gateway, or the like for coupling to the network 928. The coupling may be a wired or wireless connection. The network 928 may be the Internet, private network, an intranet, or the like.

The server 926 may also include a system memory 932 that may include a file system, ROM, RAM, and the like. The system memory 932 may include an operating system 934 similar to operating system 906 in communication devices 902. The system memory 932 may also include data structures 936 to remotely predict the remaining life of an AC motor system 110. The data structures 936 may include operations similar to those described with respect to the method 800 for remotely predicting the remaining life of an AC motor system 110. The server system memory 932 may also include other files 938, applications, modules, and the like.

The server 926 may also include a processor 942 or a processing unit to control operation of other devices in the server 926. The server 926 may also include I/O device 944. The I/O devices 944 may be similar to I/O devices 918 of communication devices 902. The server 926 may further include other devices 946, such as a monitor or the like to provide an interface along with the I/O devices 944 to the server 926. The server 926 may also include a hard disk drive 948. A system bus 950 may connect the different components of the server 926. A network interface 952 may couple the server 926 to the network 928 via the system bus 950.

The flowcharts and step diagrams in the figures illustrate the architecture, functionality, and operation of possible implementations of systems, methods, and computer program products according to various embodiments of the present invention. In this regard, each step in the flowchart or step diagrams may represent a module, segment, or portion of code, which comprises one or more executable instructions for implementing the specified logical function(s). It should also be noted that, in some alternative implementations, the functions noted in the step may occur out of the order noted in the figures. For example, two steps shown in succession may, in fact, be executed substantially concurrently, or the steps may sometimes be executed in the reverse order, depending upon the functionality involved. It will also be noted that each step of the step diagrams and/or flowchart illustration, and combinations of steps in the step diagrams and/or flowchart illustration, can be implemented by special purpose hardware-based systems which perform the specified functions or acts, or combinations of special purpose hardware and computer instructions.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Although specific embodiments have been illustrated and described herein, it should be appreciated that any arrangement, which is calculated to achieve the same purpose, may be substituted for the specific embodiments shown and that the invention has other applications in other environments. This application is intended to cover any adaptations or variations of the present invention. The following claims are in no way intended to limit the scope of the invention to the specific embodiments described herein.

For completeness, various aspects of the invention are now set out in the following numbered clauses:

1. A method of remotely determining both reliability and a remaining time before a failure for at least one AC motor system located on a site, the method comprising:

> providing at least one remote monitoring and diagnostics (RM&D) system, wherein the at least one RM&D system is at a location different from the site having the at least one AC motor system;
>
> integrating the at least one RM&D system with at least one condition forecaster,

wherein the at least one condition forecaster receives a plurality of operating data from the at least one AC motor system;

receiving the plurality of operating data from the condition forecaster;

transmitting a plurality of historical operating data corresponding to the at least one AC motor system from at least one historical database to the at least one RM&D system;

utilizing the plurality of operating data to determine whether reliability and the remaining time before the failure of the at least one AC motor system are within an alarm range; and

if reliability and the remaining time before the failure of the at least one AC motor system are within the alarm range; then notifying at least one support network.

2. The method of clause 1, wherein the step of integrating the at least one RM&D system with the at least one condition forecaster further comprises:

> the at least one condition forecaster performing at least one failure analysis based on a composite of reliability probability distributions corresponding to predetermined sub-populations of historical failure causes relating to the at least one AC motor system;
>
> the at least one condition forecaster developing at least one causal network for modeling reliability of a plurality of AC motor systems, including the at least one AC motor system and assessing at least one AC motor system component condition based on the at least one causal network; and
>
> the at least one condition forecaster performing at least one integrated causal network and reliability analysis of the at least one AC motor system, wherein results from the at least one analysis is integrated with results from the step of assessing the at least one AC motor system component condition based on the at least one causal network to compute a quantitative value for a time remaining before the failure.

3. The method of clause 1, wherein the step of receiving the plurality of operating data from the condition forecaster further comprises receiving at least one leakage current data from at least one tan delta sensor.

4. The method of clause 2, wherein the step of developing the at least one causal network further comprises utilizing Fuzzy Logic.

5. The method of clause 2, wherein the step of performing the at least one failure analysis comprises modeling a failure rate of at least one component of the AC motor system using a Weibull probability distribution function.

6. The method of clause 2, wherein the step of receiving the at least one leakage current data further comprises receiving at least one leakage current phase data.

7. The method of clause 2 further comprising determining an insulation breakdown responsive to the leakage current data.

8. The method of clause 1, further comprising integrating the at least one RM&D system with at least one remote AC motor system, wherein the at least one remote AC motor system is at a location different from the site having the at least one AC motor system.

9. A method of remotely determining both reliability and a remaining time before a failure for at least one AC motor system located on a site, the method comprising:

> providing at least one remote monitoring and diagnostics (RM&D) system, wherein the at least one RM&D system is at a location different from the site having the at least one AC motor system;
> integrating the at least one RM&D system with at least one condition forecaster,

wherein the at least one condition forecaster receives a plurality of operating data from the at least one AC motor system; wherein the at least one condition forecaster comprises the steps of:

> performing at least one failure analysis based on a composite of reliability probability distributions corresponding to predetermined sub-populations of historical failure causes relating to the at least one AC motor system;
>
> developing at least one causal network for modeling reliability of a plurality of AC motor systems, including the at least one AC motor system and assessing at least one AC motor system component condition based on the causal network; and

performing at least one integrated causal network and reliability analysis of the at least one AC motor system utilizing a Weibull probability distribution function;

wherein results from the at least one analysis is integrated with results from the step of assessing the at least one AC motor system component condition based on the at least one causal network to compute a quantitative value for a time remaining before the failure;

transmitting the plurality of operating data from the condition forecaster to the at least one RM&D system, wherein the plurality of operating data comprises data from at least one tan delta sensor;

receiving a plurality of historical operating data corresponding to the at least one AC motor system from at least one historical database;

utilizing the plurality of operating data to determine whether reliability and a remaining time before a failure of the at least one AC motor system are within an alarm range; and

if reliability and the remaining time before the failure of the at least one AC motor system are within the alarm range; then notifying at least one support network.

10. The method of clause 9, wherein the step of receiving the plurality of operating data of the at least one AC motor system further comprises receiving at least one leakage current data;

wherein the at least one leakage current data comprises data from at least one tan delta sensor; and wherein the at least one leakage current data comprises data from at least one leakage current phase data.

11. The method of clause 10, wherein the step of performing the at least one failure analysis further comprises determining an insulation breakdown of at least one AC motor system component responsive to leakage current data measured at the at least one AC motor system.

12. The method of clause 9, further comprising integrating the at least one RM&D system with at least one remote AC motor system, wherein the at least one remote AC motor system is at a location different from the site having the at least one AC motor system.

13. A system for remotely determining both reliability and a remaining time before a failure for at least one AC motor system located on a site, the system comprising:

at least one remote monitoring and diagnostics (RM&D) system, wherein the at least one RM&D system is located at a site different from the site having the at least one AC motor system, wherein the at least one RM&D system monitors a plurality of operating data of the at least one AC motor system;

at least one condition forecaster, wherein the at least one condition forecaster:

performs at least one failure analysis based on a composite of reliability probability distributions corresponding to predetermined sub-populations of historical failure causes relating to the at least one AC motor system;

develops at least one causal network for modeling reliability of a plurality of AC motor systems, including the at least one AC motor system and assessing at least one AC motor system component condition based on the causal network; and

performs at least one integrated causal network and reliability analysis of the at least one AC motor system; wherein results from the at least one analysis is integrated with results from the step of assessing the at least one AC motor system component condition based on the at least one causal network to compute a quantitative value for a time remaining before the failure;

wherein the plurality of operating data comprises data from at least one tan delta sensor;

means for integrating the at least one RM&D system with the at least one condition forecaster; and means for transmitting the plurality of operating data from the condition forecaster to the at least one RM&D system.

14. The system of clause 13, further comprising means for integrating the at least one RM&D system with at least one remote AC motor system; wherein the at least one remote AC motor system is at a location different from the site having the at least one AC motor system.

15. The system of clause 13, wherein the at least one condition forecaster receives at least one leakage current data;

wherein the at least one leakage current data comprises data from the at least one tan delta sensor; and wherein the at least one leakage current data further comprises at least one leakage current phase data.

16. The system of clause 13, wherein the at least one condition forecaster further comprises at least one structure, wherein the at least one structure predicts an insulation breakdown responsive to a leakage current data; and an insulation breakdown of at least one AC motor system component responsive to the leakage current data measured at the at least one AC motor system.

17. The system of clause 13, wherein the at least one causal network comprises means for utilizing Fuzzy Logic.

18. The system of clause 13, wherein the at least one condition forecaster comprises means for utilizing a Weibull probability distribution function.

19. The system of clause 13 further comprising:

means for receiving a plurality of historical operating data corresponding to the at least one AC motor system from at least one historical database;

means for utilizing the plurality of operating data to determine whether reliability and a remaining time before a failure of the at least one AC motor system are within an alarm range; and

means for determining if reliability and the remaining time before failure of the at least one AC motor system are within the alarm range; and for notifying at least one support network.

**Claims**

1. A method of remotely determining both reliability and a remaining time before a failure for at least one AC motor system (110) located on a site (100), the method comprising:

providing at least one remote monitoring and diagnostics (RM&D) system (150),

wherein the at least one RM&D system (150) is at a location different from the site (100) having the at least one AC motor system (110); integrating the at least one RM&D system (150) with at least one condition forecaster (140), wherein the at least one condition forecaster receives a plurality of operating data from the at least one AC motor system; receiving the plurality of operating data from the condition forecaster (140); transmitting a plurality of historical operating data corresponding to the at least one AC motor system (110) from at least one historical database to the at least one RM&D system (150); utilizing the plurality of operating data to determine whether reliability and the remaining time before the failure of the at least one AC motor system (110) are within an alarm range; and if reliability and the remaining time before the failure of the at least one AC motor system (110) are within the alarm range; then notifying at least one support network.

2. The method of claim 1, wherein the step of integrating the at least one RM&D system (150) with the at least one condition forecaster (140) further comprises:

the at least one condition forecaster (140) performing at least one failure analysis based on a composite of reliability probability distributions corresponding to predetermined sub-populations of historical failure causes relating to the at least one AC motor system; the at least one condition forecaster developing at least one causal network for modeling reliability of a plurality of AC motor systems, including the at least one AC motor system and assessing at least one AC motor system component condition based on the at least one causal network; and the at least one condition forecaster (140) performing at least one integrated causal network and reliability analysis of the at least one AC motor system (110), wherein results from the at least one analysis is integrated with results from the step of assessing the at least one AC motor system component condition based on the at least one causal network to compute a quantitative value for a time remaining before the failure.

3. The method of claim 1 or claim 2, wherein the step of receiving the plurality of operating data (120) from the condition forecaster further comprises receiving at least one leakage current data from at least one tan delta sensor.

4. The method of claim 2, wherein the step of developing the at least one causal network further comprises utilizing Fuzzy Logic.

5. The method of claim 2, wherein the step of performing the at least one failure analysis comprises modeling a failure rate of at least one component of the AC motor system (110) using a Weibull probability distribution function.

6. The method of claim 2, wherein the step of receiving the at least one leakage current data further comprises receiving at least one leakage current phase data.

7. The method of claim 2 further comprising determining an insulation breakdown responsive to the leakage current data.

8. The method of any of the preceding claims, further comprising integrating the at least one RM&D system (150) with at least one remote AC motor system (110), wherein the at least one remote AC motor system is at a location different from the site having the at least one AC motor system.

9. A method of remotely determining both reliability and a remaining time before a failure for at least one AC motor system (110) located on a site (100), the method comprising:

providing at least one remote monitoring and diagnostics (RM&D) system (150),

wherein the at least one RM&D system is at a location different from the site having the at least one AC motor system (110); integrating the at least one RM&D system (150) with at least one condition forecaster (140), wherein the at least one condition forecaster receives a plurality of operating data (120) from the at least one AC motor system; wherein the at least one condition forecaster comprises the steps of:

performing at least one failure analysis based on a composite of reliability probability distributions corresponding to predetermined sub-populations of historical failure causes relating to the at least one AC motor system; developing at least one causal network for modeling reliability of a plurality of AC motor systems, including the at least one AC motor system and assessing at least one AC motor system component condition based on the causal network; and performing at least one integrated causal network and reliability analysis of the at least one AC motor system utilizing a Weibull probability distribution function;

wherein results from the at least one analysis is integrated with results from the step of assessing the at least one AC motor system component condition based on the at least one causal network to compute a quantitative value for a time remaining before the failure; transmitting the plurality of operating data (120) from the condition forecaster (140) to the at least one RM&D system (150), wherein the plurality of operating data comprises data from at least one tan delta sensor;

receiving a plurality of historical operating data corresponding to the at least one AC motor system from at least one historical database; utilizing the plurality of operating data to determine whether reliability and a remaining time before a failure of the at least one AC motor system are within an alarm range; and if reliability and the remaining time before the failure of the at least one AC motor system are within the alarm range; then notifying at least one support network.

10. The method of claim 9, wherein the step of receiving the plurality of operating data (120) of the at least one AC motor system (110) further comprises receiving at least one leakage current data; wherein the at least one leakage current data comprises data from at least one tan delta sensor; and wherein the at least one leakage current data comprises data from at least one leakage current phase data.

11. The method of claim 10, wherein the step of performing the at least one failure analysis further comprises determining an insulation breakdown of at least one AC motor system (110) component responsive to leakage current data measured at the at least one AC motor system.

12. The method of any of claims 9 to 11, further comprising integrating the at least one RM&D system (150) with at least one remote AC motor system (110), wherein the at least one remote AC motor system is at a location different from the site having the at least one AC motor system.

13. A system for remotely determining both reliability and a remaining time before a failure for at least one AC motor system (110) located on a site, the system comprising:

at least one remote monitoring and diagnostics (RM&D) system (150), wherein the at least one RM&D system is located at a site different from the site having the at least one AC motor system (110), wherein the at least one RM&D system monitors a plurality of operating data of the at least one AC motor system; at least one condition forecaster (140), wherein the at least one condition forecaster:

performs at least one failure analysis based on a composite of reliability probability distributions corresponding to predetermined sub-populations of historical failure causes relating to the at least one AC motor system; develops at least one causal network for modeling reliability of a plurality of AC motor systems, including the at least one AC motor system and assessing at least one AC motor system component condition based on the causal network; and

performs at least one integrated causal network and reliability analysis of the at least one AC motor system; wherein results from the at least one analysis is integrated with results from the step of assessing the at least one AC motor system component condition based on the at least one causal network to compute a quantitative value for a time remaining before the failure;

wherein the plurality of operating data comprises data (120) from at least one tan delta sensor;

means for integrating the at least one RM&D system (150) with the at least one condition forecaster (140); and

means for transmitting the plurality of operating data (120) from the condition forecaster to the at least one RM&D system (150).

**14.** The system of claim 13, further comprising means for integrating the at least one RM&D system (150) with at least one remote AC motor system (110); wherein the at least one remote AC motor system is at a location different from the site having the at least one AC motor system.

**15.** The system of claim 13 or 14, wherein the at least one condition forecaster receives at least one leakage current data;

wherein the at least one leakage current data comprises data from the at least one tan delta sensor; and

wherein the at least one leakage current data further comprises at least one leakage current phase data.

FIG. 1

110 Motor

120 Operating Data

100

130 Data Storage Device

140 AC Motor Condition Forecaster

150

160 Operator Notification Generator

Machine Performance Issue

170

Support Notification Generator

EP 2 051 086 A2

## FIG. 2

Infant Mortality | "Useful" Life | Wear Out

Bath Tub Curve (composite)

External Stress Failures

Failure Rate

$T_{burn-in}$      $T_{wear-out}$

Manufacturing Defects

Service Time

Wear Out Failures

**Electrical Issues**

**Motor Slip**
- Low Voltage

**Insulation**
- Ungrounded power system
- Mechanical damage
- Contaminants
- Excessive temperature
- Voltage surge
- Excessive vibration
- Shaft currents
- Heat dissipation

**Windings**
- Overheating
- Excessive current
- Unbalanced a-c current
- Improper ventilation
- Short circuit (coil/winding)
- Reverted coil fields
- Dirty windings
- Unbalanced voltage
- Open circuit field windings
- Negative sequence currents

**Field**
- Shorted turns
- Shorted field coil
- System harmonics

**Air Quality**
- Chemical oxidation reduction
- Ambient temperature
- Water/moisture
- Altitude

**Overheating**
- Low voltage
- Over voltage
- Improper ventilation
- High ambient temp.

**Environmental Issues**

**Mechanical Issues**

**Bearing Housing**
- Oil leak
- Restricted drain
- Bent shaft
- Loose fasteners

**Collector Ring**
- Brush current density low, scoring quickly

**Component Wear**
- Excessive vibration
- Rotor unbalance
- Rubbing parts
- Loose parts
- Oil film instabilities
- Resonance

**Manpower**
- Maintenance-Training
- Repair-Training
- Lubrication-mix, quantity
- Motor overload
- Too many starts
- Ventilation
- Connected wrong
- Wrong bearings

**Systemic Issues**

**Brushes (DC)**
- Broken spring
- Pitted collector rings
- Misalignment
- Worn, broken or burned brushes
- Contaminated cooling air
- Oil contamination

**Bearing**
- Electric current through bearing
- Rough surface
- Excessive vibration
- Electrically induced vibration
- Loss of lubrication
- Misalignment

**Motor system trips off-line unexpectedly**

**Vibration Energy**
- Unbalance
- Electric rotor
- Misalignment
- Driven equipment induced
- Uneven air gap
- Resonance
- Rotor bars

**Generator**
- Writing to watt meters

*FIG. 3*

## FIG. 4

400

Start

401 — Historical Data

402 — Real-Time operational Data

403 — Update & clean historical database

404 — Set sensor limits and load into database

406 — Data Quality Check & Purge

No

411 — Corrective action to fix problem source

Yes

409 — Exclude data from analysis if not sufficient quality

405 — Data Quality Check & Purge

No

408 — Casual network assesses condition of equipment

Yes

Yes

410 — Can fixup problem source?

407 — Failure analysis based on composite reliability distributions from subpopulations

412 — Estimate reliability using parameters identified by causal network assessment

No

415 — Issue/display error/alarm notification

414 — View results

**FIG. 5**

500

| 501 | 502 | 503 | 504 | 505 |
|---|---|---|---|---|
| Identify historical data sources for the type of AC motor system | Data assessment to establish data scarcity and quality | Integrate data, if from multiple sources | Structure the data for use in the analytical engine | Split data into validation and calibration data |

| 506 | 507 | 508 | 509 | 510 | 511 |
|---|---|---|---|---|---|
| Construct fault tree libraries for motor components | Construct system fault models, such as reliability block diagrams | Fit failure/life probability models to historical data, e.g., probability distributions | Construct FMEA libraries | Construct directed causal inference model, such as fuzzy logic | Select data variables for collection based upon model in the causal network |

| 512 | 513 | 514 | 515 | 516 | 517 |
|---|---|---|---|---|---|
| Determine system hierarchy of machine component model | Assemble a structured system of conditional probability matrices | Extract hypothesized systems model, including covariant/conditional dependencies | Calibrate model with data from probability distributions | Validate model using data from probability distributions | Begin collecting data |

| 518 | 519 | 520 | 521 | 522 | 523 |
|---|---|---|---|---|---|
| Set thresholds and monitor data | Model predicts current system state | Model predicts expected time to failure of components and causes | Assess model performance | Determine maintenance plan from analysis | Update historical database; evolve and optimize model |

Unacceptable

524 — Further analysis needed?  Yes / No → End

EP 2 051 086 A2

## FIG. 6

## FIG. 7

**FIG. 8**

800

810 — Receive Operating Data

Data Storage Device

130

830 — Apply Condition Forecaster Engine

840 — At Least One Rule Triggered ?

No

850 — Operator Notification Required?

N

860 — Notify Operator

870 — Notify Support

FIG. 9